(19) Europäisches Patentamt / European Patent Office / Office européen des brevets

(11) **EP 3 168 316 B1**

(12) **FASCICULE DE BREVET EUROPEEN**

(45) Date de publication et mention de la délivrance du brevet:
**26.12.2018 Bulletin 2018/52**

(51) Int Cl.:
*C22C 21/02* (2006.01)      *B01J 3/00* (2006.01)
*C25D 11/04* (2006.01)      *C25D 11/08* (2006.01)
*C25D 11/10* (2006.01)      *C22C 21/08* (2006.01)
*C22F 1/05* (2006.01)      *H01J 37/32* (2006.01)

(21) Numéro de dépôt: **16205240.1**

(22) Date de dépôt: **15.10.2013**

(54) **ELEMENT DE CHAMBRES A VIDE EN ALLIAGE D'ALUMINIUM**

VAKUUMKAMMERELEMENT AUS ALUMINIUMLEGIERUNG

VACUUM CHAMBER ELEMENT IN ALUMINIUM ALLOY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2012 FR 1202766**
**19.11.2012 US 201261728021 P**

(43) Date de publication de la demande:
**17.05.2017 Bulletin 2017/20**

(62) Numéro(s) de document de la (des) demande(s) initiale(s) en application de l'article 76 CBE:
**13792051.8 / 2 909 351**

(73) Titulaires:
• **Constellium Issoire**
**63500 Issoire (FR)**
• **Constellium Valais SA (AG, Ltd)**
**3960 Sierre (CH)**

(72) Inventeurs:
• **VAN KAPPEL, Joost**
**3960 SIERRE (CH)**
• **GASQUERES, Cédric**
**13100 AIX-EN-PROVENCE (FR)**
• **PIPPIG SCHMID, Kristin**
**9000 ST GALLEN (CH)**
• **DAVO GUTIERREZ, Belen**
**38500 COUBLEVIE (FR)**

(74) Mandataire: **Constellium - Propriété Industrielle C-TEC Constellium Technology Center Propriété Industrielle Parc Economique Centr'Alp 725, rue Aristide Bergès CS10027 38341 Voreppe (FR)**

(56) Documents cités:
JP-A- 2001 220 637      US-A1- 2001 019 777
US-A1- 2010 200 205

## Description

### Domaine de l'invention

L'invention concerne des produits en alliage d'aluminium destinés à être utilisés comme éléments de chambres à vide notamment pour la fabrication de circuits électroniques intégrés à base de semi-conducteurs, d'écrans d'affichage plats ainsi que de panneaux photovoltaïques et leur procédé de fabrication.

### Etat de la technique

Les éléments de chambres à vide pour la fabrication de circuits électroniques intégrés à base de semi-conducteurs, d'écrans d'affichage plats ainsi que de panneaux photovoltaïques, peuvent typiquement être obtenus à partir de tôles en alliage d'aluminium.

Les éléments de chambre à vide sont des éléments destinés à la fabrication des structures de chambre à vide et des composants internes de chambre à vide notamment des corps de chambres à vide, des corps de vanne, des brides, des éléments de connexion, des éléments d'étanchéité, des passages, des diffuseurs, des électrodes. Ils sont notamment obtenus par usinage et traitement de surface de tôles en alliage d'aluminium.

Pour obtenir des éléments de chambre à vide satisfaisants, les tôles en alliage d'aluminium doivent présenter certaines propriétés.

En effet, les tôles doivent tout d'abord présenter des caractéristiques mécaniques satisfaisantes pour réaliser par usinage des pièces présentant les dimensions et la rigidité souhaités de façon à pouvoir atteindre, sans déformation, un vide généralement du niveau au moins du vide moyen ($10^{-3}$ - $10^{-5}$ Torr). Ainsi la résistance à rupture ($R_m$) souhaitée est généralement d'au moins 260 MPa et même davantage si possible. De plus, pour être aptes à l'usinage les tôles destinées à être usinées dans la masse doivent avoir des propriétés homogènes dans l'épaisseur et présenter une faible densité d'énergie élastique stockée provenant des contraintes résiduelles.

Le niveau de porosité des tôles doit par ailleurs être suffisamment faible pour atteindre si nécessaire le haut-vide ($10^{-6}$ - $10^{-8}$ Torr). De plus, les gaz utilisés dans les chambres à vide sont fréquemment très corrosifs et de façon à éviter les risques de pollution des plaquettes de silicium ou des dispositifs à cristaux liquides par des particules ou des substances provenant des éléments de chambres à vide et/ou un remplacement fréquent de ces éléments, il est important de protéger les surfaces des éléments de chambre à vide. L'aluminium s'avère être un matériau avantageux à ce point de vue car il est possible de réaliser un traitement de surface générant une couche d'oxyde résistante aux gaz réactifs. Ce traitement de surface comprend une étape d'anodisation et la couche d'oxyde obtenue est en général appelée couche anodique. Dans le cadre de l'invention on entend plus particulièrement par « résistance à la corrosion » la résistance de l'aluminium anodisé aux gaz corrosifs utilisés dans les chambres à vides et aux tests correspondants. Cependant, la protection apportée par la couche anodique est affectée par de nombreux facteurs liés notamment à la microstructure de la tôle (taille et forme de grains, précipitation des phases, porosité) et il est toujours souhaitable d'améliorer ce paramètre. La résistance à la corrosion est notamment évaluée par le test dit « test de bulles » qui consiste à mesurer la durée d'apparition de bulles d'hydrogène en surface du produit anodisé lors du contact avec une solution diluée d'acide chlorhydrique. Les durées connues dans l'état de la technique sont de l'ordre de dizaines de minutes à quelques heures.

Pour améliorer les éléments de chambre à vide on peut améliorer les tôles en aluminium et/ou le traitement de surface réalisé.

Le brevet US 6,713,188 (Applied Materials Inc.) décrit un alliage adapté à la fabrication des chambres pour fabrication de semi-conducteur de composition (en % en poids) Si : 0,4 - 0,8; Cu : 0,15-0,30; Fe : 0;001 - 0;20 ; Mn 0,001 - 0,14 ; Zn 0,001 - 0,15 ; Cr : 0,04 - 0,28 ; Ti 0,001 - 0,06 ; Mg : 0,8 - 1,2. Les pièces sont obtenues par extrusion ou usinage jusqu'à la forme désirée. La composition permet un contrôle de la taille des particules d'impuretés ce qui améliore la performance de la couche anodique.

Le brevet US 7,033,447 (Applied Materials Inc.) revendique un alliage adapté à la fabrication des chambres pour fabrication de semi-conducteur de composition (en % en poids) Mg : 3,5 - 4,0; Cu : 0,02 - 0,07; Mn : 0;005 - 0;015 ; Zn 0,08 - 0,16 ; Cr 0,02 - 0,07 ; Ti : 0 - 0,02 ; Si < 0,03 ; Fe < 0,03 . Les pièces sont anodisées dans une solution comprenant 10% à 20% en poids d'acide sulfurique, 0,5 à 3% en poids d'acide oxalique à une température de 7 à 21 °C. Le meilleur résultat obtenu au test de bulles est de 20 heures.

Le brevet US 6,686,053 (Kobe) revendique un alliage ayant une résistance à la corrosion améliorée, dans lequel l'oxyde anodique comprend une couche barrière et une couche poreuse et dans lequel au moins une partie de la couche est altérée en boehmite et/ou pseudo-boehmite. Le meilleur résultat obtenu au test de bulles est de l'ordre de 10 heures.

La demande de brevet US 2009/0050485 (Kobe Steel, Ltd.) décrit un alliage de composition (en % en poids) Mg : 0,1 - 2,0 ; Si : 0,1 - 2,0 ; Mn : 0,1 - 2,0 ; Fe, Cr, et Cu $\leq$ 0,03, anodisé de façon à ce que la dureté de la couche d'oxyde anodique varie dans l'épaisseur. La très faible teneur en fer, chrome et cuivre entraine un surcoût important pour le métal utilisé.

La demande de brevet US 2010/0018617 (Kobe Steel, Ltd.) décrit un alliage de composition (en % en poids) Mg : 0,1 - 2,0 ; Si : 0,1 - 2,0 ; Mn : 0,1 - 2,0 ; Fe, Cr, and Cu ≤ 0,03, l'alliage étant homogénéisé à une température de plus de 550 °C jusque 600 °C ou moins.

Les demandes de brevet US 2001/019777 et JP2001 220637 (Kobe Steel) décrivent un alliage pour chambres comprenant (en % en poids) Si : 0,1 - 2,0, Mg : 0,1 - 3,5, Cu : 0,02 - 4,0 et des impuretés, la teneur en Cr étant inférieure à 0,04 %. Ces documents divulguent en particulier des produits obtenus en réalisant avant mise en solution une étape de laminage à chaud.

La demande internationale WO2011/89337 (Constellium) décrit un procédé de fabrication de produits coulés non laminés adaptés à la fabrication d'éléments de chambre à vide de composition , en % en poids, Si : 0,5 - 1,5 ; Mg : 0,5 - 1,5 ; Fe < 0,3 ; Cu < 0,2 ; Mn < 0,8 ; Cr < 0,10 ; Ti < 0,15.

Le brevet US 6,066,392 (Kobe Steel) décrit un matériau en aluminium ayant un film d'oxydation d'anodique avec une résistance à la corrosion améliorée, dans lequel des criques ne sont pas générées même dans des cycles thermiques à haute température et dans des environnements corrosifs.

Le brevet US 6,027,629 (Kobe Steel) décrit un procédé de traitement de surface amélioré pour éléments de chambres à vide dans lequel le diamètre des pores de la couche anodique est variable dans l'épaisseur de celle-ci.

Le brevet US 7,005,194 (Kobe Steel) décrit un procédé de traitement de surface amélioré pour éléments de chambres à vide dans lequel le film anodisé est composé d'une couche poreuse et d'une couche non-poreuse dont la structure est au moins en partie de la boehmite ou de la pseudo-boehmite.

Le brevet US 3,524,799 (Reynolds) décrit un revêtement anodique dur et dense formé sur une surface d'aluminium par anodisation dans un électrolyte aqueux contenant un acide minéral tel que l'acide sulfurique, un alcool polyhydrique de 3 à 6 atomes de carbone, un acide carboxylique organique et un sel alcalin d'un complexe titanique d'un acide carboxylique hydroxyaliphatique adapté aux surfaces en aluminium de véhicules spatiaux pour lesquels un revêtement blanc et lumineux est nécessaire.

Ces documents ne mentionnent pas le problème d'amélioration de l'homogénéité des propriétés dans l'épaisseur des éléments de chambre à vide. De plus la réalisation de certains éléments de chambre à vide nécessite l'utilisation de tôles épaisses typiquement d'au moins 60 mm pour lesquelles il est plus difficile d'atteindre une résistance à la corrosion satisfaisante.

Il existe un besoin pour des éléments de chambre à vide encore améliorés, en particulier en termes de résistance à la corrosion, d'homogénéité des propriétés dans l'épaisseur et d'aptitude à l'usinage. La résistance à la corrosion et les propriétés mécaniques doivent être améliorées dans toute l'épaisseur de la tôle en alliage d'aluminium notamment pour faciliter l'usinage et pour permettre la mise en contact avec l'atmosphère de la chambre de toute partie de la tôle. Il existe également un besoin de tôles épaisses améliorées en alliage d'aluminium pour la réalisation d'éléments de chambre à vide.

**Objet de l'invention**

Un objet de l'invention est un élément de chambre à vide obtenu par usinage et traitement de surface d'une tôle d'épaisseur au moins égale à 10 mm en alliage d'aluminium de composition, en % en poids, Si : 0,4 - 0,7 ; Mg : 0,4 - 0,7 ; Ti : 0,01 - < 0,15, Fe 0,05 - 0,2 ; Cu < 0,04 ; Mn < 0,4 ; Cr : 0,01 - < 0,1 ; Zn < 0,04 ; autres éléments < 0,05 chacun et < 0,15 au total, reste aluminium.

**Description des figures**

La figure 1 montre la structure granulaire des produits A à C obtenus dans l'exemple 1 sur des coupes L / TC après attaque Barker en surface, à quart-épaisseur et à mi-épaisseur.

La figure 2 montre le profil de contrainte dans l'épaisseur pour la direction L des produits obtenus dans l'exemple 1.

La figure 3 montre la structure granulaire du produit D obtenu dans l'exemple 1 sur des coupes L / TC après attaque Barker en surface, à quart-épaisseur et à mi-épaisseur.

**Description détaillée de l'invention**

La désignation des alliages se fait en conformité avec les règlements de The Aluminium Association (AA), connus de l'homme du métier. Les définitions des états métallurgiques sont indiquées dans la norme européenne EN 515. Sauf mention contraire, les définitions de la norme EN12258-1 s'appliquent.

Sauf mention contraire, les caractéristiques mécaniques statiques, en d'autres termes la résistance à la rupture Rm, la limite d'élasticité conventionnelle à 0,2% d'allongement Rp0,2 et l'allongement à la rupture A%, sont déterminées par un essai de traction selon la norme ISO 6892-1, le prélèvement et le sens de l'essai étant définis par la norme EN 485-1. La dureté est mesurée selon la norme EN ISO 6506. Les tailles de grain sont mesurées selon la norme ASTM E112. La tension de claquage est mesurée selon la norme EN ISO 2376 :2010.

Les présents inventeurs ont trouvé que des éléments de chambre à vide ayant des propriétés très avantageuses, notamment en termes de résistance à la corrosion, d'uniformité des propriétés et d'aptitude à l'usinage, sont obtenus pour un alliage d'aluminium de la série 6xxx spécifique. Un procédé de fabrication d'élément de chambre à vide comprenant un traitement de surface avantageux pour ces produits et permettant notamment d'améliorer l'homogénéité des propriétés dans l'épaisseur et la résistance à la corrosion des éléments de chambres à vide a également été inventé. Des propriétés particulièrement avantageuses sont obtenues en combinant l'alliage selon l'invention et le procédé de traitement de surface avantageux.

La composition des tôles en alliage d'aluminium permettant d'obtenir les éléments de chambre à vide selon l'invention est en % en poids, Si : 0,4 - 0,7 ; Mg : 0,4 - 0,7 ; Ti 0,01 - < 0,15, Fe 0,05 - 0,2 ; Cu < 0,04 ; Mn < 0,4 ; Cr 0.01 - < 0,1 ; Zn < 0,04 ; autres éléments < 0,05 chacun et < 0,15 au total, reste aluminium.

Le contrôle des teneurs maximales de certains éléments est important car ces éléments peuvent s'ils sont présents à des teneurs supérieures à celles préconisées dégrader les propriétés de la couche d'oxyde anodique et/ou contaminer les produits fabriqués dans les chambres à vide. Ainsi, la teneur en manganèse est inférieure à 0,4 % en poids, de préférence inférieure à 0,04 % en poids et de manière préférée inférieure à 0,02 % en poids. La teneur en cuivre est inférieure à 0,04 % en poids, de préférence inférieure à 0,02 % en poids et manière préférée inférieure à 0,01 % en poids. La teneur en zinc est inférieure à 0,04 % en poids, de préférence inférieure à 0,02 % en poids et de manière préférée inférieure à 0,001 % en poids.

Une quantité trop élevée de chrome peut également avoir un effet néfaste sur les propriétés de la couche d'oxyde anodique. Ainsi la teneur en chrome est inférieure à 0,1 % en poids. Cependant l'addition d'une faible quantité de chrome a un effet favorable sur la structure granulaire, ainsi la teneur en chrome est au moins de 0,01 % en poids. Dans une réalisation avantageuse de l'invention, la teneur en chrome est de 0,01 à 0,04 % en poids et de préférence de 0,01 à 0,03 % en poids.

Une quantité trop élevée de fer peut également avoir un effet néfaste sur les propriétés de la couche d'oxyde anodique. Cependant l'addition d'une faible quantité de fer a un effet favorable sur la coulabilité des produits. La teneur en fer est de 0,05 à 0,2 % en poids et de préférence de 0,1 à 0,2 % en poids.

Une quantité trop élevée de titane peut également avoir un effet néfaste sur les propriétés de la couche d'oxyde anodique. Ainsi la teneur en titane est inférieure à 0,15 % en poids. Cependant l'addition d'une faible quantité de titane a un effet favorable sur la structure granulaire et son homogénéité, ainsi la teneur en titane est au moins de 0,01 % en poids. Dans une réalisation avantageuse de l'invention, la teneur en titane est de 0,01 à 0,1 % en poids et de préférence de 0,01 à 0,05 % en poids. De façon avantageuse la teneur en titane est au moins de 0,02 % en poids et préférentiellement au moins 0,03 % en poids. L'addition simultanée de chrome et de titane est avantageuse car elle permet notamment d'améliorer la structure granulaire et en particulier de diminuer l'indice d'anisotropie des grains.

Le magnésium et le silicium sont les éléments majeurs d'addition dans les produits en alliage selon l'invention. Leur teneur a été choisie avec précision de façon à atteindre des propriétés mécaniques suffisantes, notamment une résistance à la rupture dans le sens TL d'au moins 260 MPa et/ou une limite d'élasticité dans le sens TL d'au moins 200 MPa et également une structure granulaire homogène dans l'épaisseur. La teneur en silicium est comprise entre 0,4 et 0,7 % en poids et de préférence entre 0,5% et 0,6 % en poids. La teneur en magnésium est comprise entre 0,4 et 0,7 % en poids et de préférence entre 0,5% et 0,6 % en poids.

Les tôles en alliage d'aluminium selon l'invention ont une épaisseur d'au moins 10 mm. Typiquement, les tôles en alliage d'aluminium selon l'invention ont une épaisseur comprise entre 10 et 60 mm. Cependant, les présents inventeurs ont constaté que des tôles en alliage d'aluminium selon l'invention sont avantageuses lorsqu'une épaisseur d'au moins 60 mm est souhaitée.

Les tôles permettant d'obtenir les éléments de chambre à vide selon l'invention sont obtenues par un procédé dans lequel

   a. on coule une plaque de laminage en alliage selon l'invention,
   b. optionnellement, on homogénéise ladite plaque de laminage,
   c. on lamine ladite plaque de laminage à une température supérieure à 450 °C pour obtenir une tôle d'épaisseur au moins égale à 10 mm,
   d. on réalise un traitement de mise en solution de ladite tôle et on la trempe,
   e. on détensionne ladite tôle ainsi mise en solution par traction contrôlée avec un allongement permanent de 1 à 5%,

f. on réalise un revenu de la tôle ainsi tractionnée.

L'homogénéisation est avantageuse, elle est de préférence réalisée à une température comprise entre 540 et 600 °C. Préférentiellement la durée d'homogénéisation est d'au moins 4h.

Quand une homogénéisation est réalisée, la plaque peut être refroidie après homogénéisation puis réchauffée avant le laminage à chaud ou directement laminée après homogénéisation sans refroidissement intermédiaire. Les conditions de laminage à chaud sont importantes pour obtenir la microstructure souhaitée, notamment pour améliorer la résistance à la corrosion des produits. En particulier, la plaque de laminage est maintenue à une température supérieure à 450 °C tout au long du laminage à chaud. De manière préférée, la température du métal est au moins 480 °C lors du laminage à chaud. Les tôles selon l'invention sont laminées jusqu'à une épaisseur d'au moins 10 mm. L'homogénéité de la microstructure dans l'épaisseur, la nature equiaxe des grains et la microstructure favorable pour l'amélioration de la résistance à la corrosion des produits selon l'invention est particulièrement avantageuse, elle est favorisée par le choix d'une température de laminage à chaud élevée en combinaison avec une composition comportant une quantité optimale d'éléments anti-recristallisants.

On réalise ensuite un traitement de mise en solution de la tôle et une trempe. La trempe peut être réalisée notamment par aspersion ou par immersion. La mise en solution est de préférence réalisée à une température comprise entre 540 et 600 °C. Préférentiellement la durée de mise en solution est d'au moins 15 min, la durée étant adaptée en fonction de l'épaisseur des produits.

La tôle ainsi mise en solution est ensuite détensionnée par traction contrôlée avec un allongement permanent de 1 à 5%.

Un revenu de la tôle ainsi tractionnée est ensuite réalisé. La température de revenu est avantageusement comprise entre 150 et 190 °C. La durée de revenu est typiquement comprise entre 5 et 30h. De préférence on réalise un revenu au pic permettant d'atteindre une limite d'élasticité maximale et/ou un état T651.

La tôle ainsi obtenue a une taille de grain particulièrement homogène dans l'épaisseur. Préférentiellement la variation dans l'épaisseur de la longueur moyenne d'interception linéaire dans le plan L/TC, nommée $\overline{\ell}_{\ell(90°)}$ selon la norme ASTM E112, de ladite tôle est inférieure à 30 % et de préférence inférieure à 20% et même avantageusement inférieure à 15%. La variation de la taille de grain est calculée en prenant la différence entre la valeur maximale et la valeur minimale à ½ épaisseur, ¼ épaisseur et surface et en divisant par la moyenne des valeurs à ½ épaisseur, ½ épaisseur et surface. L'homogénéité de la structure granulaire, qui provient de la combinaison entre la composition sélectionnée et la gamme de transformation effectuée est particulièrement avantageuse car les propriétés de l'élément de chambre à vide obtenu après usinage sont très homogènes en tout point. La structure granulaire des tôles selon l'invention est plus isotrope que celle des tôles de l'art antérieur, quelle que soit la position dans l'épaisseur ce qui est avantageux pour les propriétés de résistance à la corrosion, d'homogénéité des propriétés dans l'épaisseur et d'aptitude à l'usinage pour la réalisation d'éléments de chambres à vide. En particulier, à mi-épaisseur l'indice d'anisotropie $AI_{\ell}$ = $\overline{\ell}_{\ell(0°)} / \overline{\ell}_{\ell(90°)}$ mesuré selon la norme ASTM E112 est inférieur à 3.

La tôle ainsi obtenue est particulièrement apte à l'usinage. Ainsi la densité d'énergie élastique stockée $W_{tot}$, dont la mesure est décrite dans l'exemple 1, dans une tôle selon l'invention dont l'épaisseur est comprise entre 10 et 60 mm est avantageusement inférieure à 0,04 kJ/m$^3$.

Un élément de chambre à vide est obtenu par usinage et traitement de surface d'une tôle d'épaisseur au moins égale à 10 mm en alliage d'aluminium selon l'invention.

Le traitement de surface comprend un traitement d'anodisation pour obtenir une couche anodique dont l'épaisseur est typiquement comprise entre 20 et 80 $\mu$m.

Le traitement de surface comprend de préférence avant anodisation un dégraissage et/ou un décapage avec des produits connus, typiquement des produits alcalins. Le dégraissage et/ou décapage peut comprendre une opération de neutralisation notamment en cas de décapage alcalin, typiquement avec un produit acide tel que l'acide nitrique, et/ou au moins une étape de rinçage.

L'anodisation est réalisée à l'aide d'une solution acide. Il est avantageux que le traitement de surface comprenne après anodisation une hydratation (aussi appelée « colmatage ») de la couche anodique ainsi obtenue.

Du fait de la structure homogène dans l'épaisseur des produits selon l'invention, la variation entre la durée d'apparition de bulles d'hydrogène dans une solution d'acide chlorhydrique 5% (« test de bulles ») entre ½ épaisseur et surface est avantageusement inférieure à 20%, notamment lorsque l'épaisseur de la tôle est comprise entre 10 et 60 mm.

Les présents inventeurs ont de plus constaté que le procédé de fabrication d'élément de chambre à vide dans lequel successivement

- on approvisionne une tôle en alliage d'aluminium selon l'invention dont l'épaisseur est au moins 10 mm
- on usine ladite tôle en élément de chambre à vide
- on dégraisse et/ou on décape le dit élément

- on anodise à une température comprise entre 10 et 30 °C avec une solution comprenant 100 à 300 g/l d'acide sulfurique et 10 à 30 g/l d'acide oxalique et 5 à 30 g/l d'au moins un polyol,
- optionnellement on hydrate le produit ainsi anodisé dans de l'eau déionisée à une température d'au moins 98 °C préférentiellement pendant une durée d'au moins environ 1 h est avantageux.

Notamment, ces conditions d'anodisation avantageuses permettent d'atteindre tant en surface qu'à mi-épaisseur, des durées d'apparition de bulles d'hydrogène au test de bulles particulièrement remarquables pour les alliages selon l'invention. Ces conditions d'anodisation avantageuses donnent des résultats particulièrement remarquables pour les produits en alliage selon l'invention.

Ainsi, on réalise dans le procédé de fabrication d'un élément de chambre à vide selon l'invention un procédé de traitement de surface avantageux comprenant l'anodisation à une température comprise entre 10 et 30 °C avec une solution aqueuse comprenant 100 à 300 g/l d'acide sulfurique et 10 à 30 g/l d'acide oxalique et 5 à 30 g/l d'au moins un polyol. Préférentiellement, la solution aqueuse utilisée pour l'anodisation de ce traitement de surface avantageux ne contient pas de sel de titane. Les présents inventeurs ont en particulier constaté que les anodisations réalisées à basse température, typiquement entre 0 et 5 °C, ne permettent pas d'atteindre une résistance à la corrosion aussi élevée que celle obtenue à une température comprise entre 10 et 30 °C. La présence d'au moins un polyol dans la solution d'anodisation contribue également à l'amélioration de la résistance à la corrosion des couches anodiques. L'éthylène glycol, le propylène glycol ou de préférence le glycérol sont des polyols avantageux. L'anodisation est de préférence réalisée avec une densité de courant comprise entre 1 et 5 A/dm$^2$. La durée d'anodisation est déterminée de façon à atteindre l'épaisseur de couche anodique recherchée.

Après anodisation, il est avantageux de réaliser une étape d'hydratation (aussi appelée colmatage) de la couche anodique. De préférence l'hydratation est réalisée dans de l'eau déionisée à une température d'au moins 98 °C préférentiellement pendant une durée d'au moins environ 1 h. Les présents inventeurs ont observé qu'il est particulièrement avantageux de réaliser l'hydratation postérieure à l'anodisation en deux étapes dans de l'eau déionisée, une première étape d'une durée d'au moins 10 min à une température de 20 à 70 °C et une seconde étape d'une durée d'au moins environ 1 h à une température d'au moins 98 °C. Avantageusement un additif antipoudrant dérivé de triazine tel que le Anodal-SH1® est ajouté à l'eau déionisée utilisée pour la deuxième étape de l'hydratation.

Les éléments de chambres à vide obtenus à partir d'une tôle en alliage selon l'invention dont l'épaisseur est comprise entre 10 et 60 mm et avec le procédé de traitement de surface avantageux présentent à mi-épaisseur de la tôle une durée d'apparition de bulles d'hydrogène dans une solution d'acide chlorhydrique 5% supérieure à 1800 min soit 30 heures. Les éléments de chambres à vide obtenus à partir d'une tôle en alliage selon l'invention dont l'épaisseur est supérieure à 60 mm et avec le procédé de traitement de surface avantageux présentent en surface de la tôle une durée d'apparition de bulles d'hydrogène dans une solution d'acide chlorhydrique 5% d'au moins 180 min et de préférence d'au moins 300 min.

L'utilisation des éléments de chambre à vide selon l'invention dans des chambres à vide est particulièrement avantageuse car leur propriétés sont très homogènes et de plus, notamment pour les éléments anodisés avec le procédé de traitement de surface avantageux, la résistance à la corrosion est élevée ce qui permet d'éviter la pollution des produits fabriqués dans les chambres tels que par exemple que les microprocesseurs ou les dalles pour écrans plats.

**Exemples**

Exemple 1

Dans cet exemple des tôles en alliage 6xxx d'épaisseur 20 mm ou 35 mm ont été préparées. Des plaques dont la composition est donnée dans le Tableau 1 ont été coulées.

Tableau 1 - composition des alliages (% en poids)

| Alliage | Si | Fe | Cu | Mn | Mg | Cr | Ti | Zn |
|---|---|---|---|---|---|---|---|---|
| A (Invention) | 0,5 | 0,12 | < 0,01 | < 0,01 | 0,5 | 0,02 | 0,04 | < 0,01 |
| B (Référence) | 0,6 | 0,15 | 0,16 | 0,01 | 1,1 | 0,06 | 0,02 | < 0,01 |
| C (Référence) | 0,6 | 0,12 | 0,18 | < 0,01 | 1,0 | 0,19 | 0,02 | < 0,01 |
| D (Référence) | 0,6 | 0,15 | < 0,01 | 0,3 | 0,7 | < 0,01 | 0,01 | < 0,01 |

Les plaques ont été homogénéisées à une température supérieure à 540 °C (A à C) ou 575 °C (D), laminées à chaud jusqu'à une épaisseur de 35 mm (A à C) ou 20 mm (D) puis mises en solution, trempées et tractionnées. Les tôles obtenues ont subi un revenu adapté pour atteindre un état T651.

Les propriétés mécaniques dans la direction TL ont été mesurées à mi-épaisseur et sont rapportées dans le Tableau 2

Tableau 2 - propriétés mécaniques à mi-épaisseur dans la direction TL

| Alliage | Rp0,2 (MPa) | Rm (MPa) | A(%) |
|---|---|---|---|
| A (Invention) | 215 | 275 | 15 |
| B (Référence) | 306 | 342 | 12 |
| C (Référence) | 300 | 332 | 14 |
| D (Référence) | 249 | 274 | 13 |

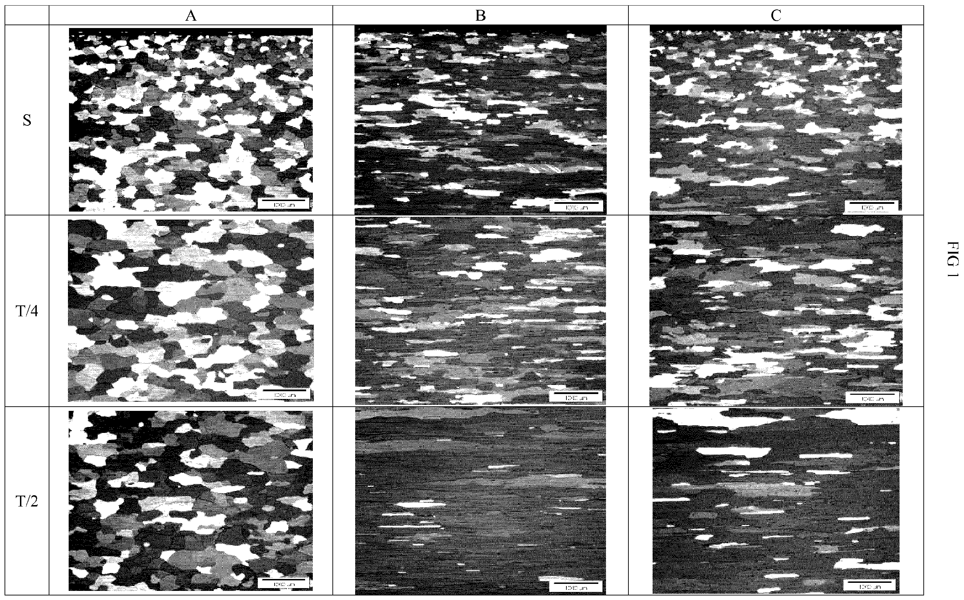

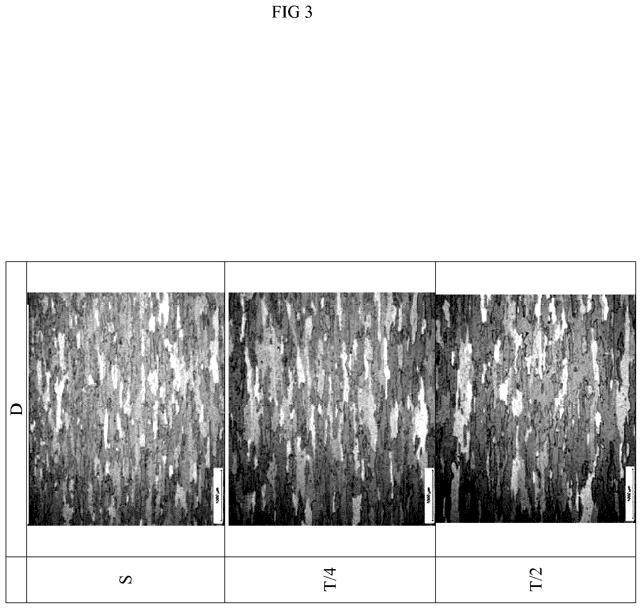

La structure granulaire des différents produits obtenus a été observée sur des coupes L / TC par microscopie optique après attaque Barker, en surface à quart et mi-épaisseur. Les micrographies sont présentées sur les Figures 1 et 3.

Les tailles de grain moyennes mesurées dans le plan L/TC selon la méthode d'interceptes de la norme (ASTM E112-96 §16.3) sont présentées dans le Tableau 3. La longueur moyenne d'interception linéaire est donnée dans le sens longitudinal $\overline{\ell}_{\ell(0°)}$ et le sens transverse $\overline{\ell}_{\ell(90°)}$. Une valeur moyenne dans le plan L/TC est calculée : $\overline{\ell} = (\overline{\ell}_{\ell(0°)}.\overline{\ell}_{\ell(90°)})^{1/2}$. L'indice d'anisotropie $AI_\ell = \overline{\ell}_{\ell(0°)}/\overline{\ell}_{\ell(90°)}$ est également calculé. On calcule également la variation dans l'épaisseur de $\overline{\ell}_{\ell(90°)}$, $\Delta\overline{\ell}_{\ell(90°)}$ selon la formule :

$$\Delta\, \overline{\ell}_{\ell(90°)} = (\max(\overline{\ell}_{\ell(90°)}\,(\text{S}, \tfrac{1}{2}\text{Ep}, \tfrac{1}{4}\text{Ep})) - \min(\overline{\ell}_{\ell(90°)}\,(\text{S}, \tfrac{1}{2}\text{Ep}, \tfrac{1}{4}\text{Ep})))/\,\text{moy}(\overline{\ell}_{\ell(90°)}\,(\text{S}, \tfrac{1}{2}\text{Ep}, \tfrac{1}{4}\text{Ep}))$$

dans laquelle S :signifie Surface, ½ Ep signifie mi-épaisseur et ¼ Ep signifie quart-épaisseur.

Tableau 3 - taille de grain dans le plan L - TC ($\mu$m)

| Alliage | Position | $\overline{\ell}_{\ell(90°)}$ $\mu$m | $\overline{\ell}_{\ell(0°)}$· $\mu$m | $\overline{\ell}$$\mu$m | $AI_\ell$ (L/TC) | $\Delta\overline{\ell}_{\ell(90°)}$ |
|---|---|---|---|---|---|---|
| A | Surface | 171 | 293 | 224 | 1,7 | |
| | ¼ épaisseur | 188 | 390 | 271 | 2,1 | 11% |
| | ½ épaisseur | 190 | 421 | 283 | 2,2 | |
| B | Surface | 106 | 351 | 193 | 3,3 | |
| | ¼ épaisseur | 124 | 438 | 233 | 3,5 | 45% |
| | ½ épaisseur | 166 | 1500 | 499 | 9,0 | |
| C | Surface | 103 | 618 | 252 | 6,0 | |
| | ¼ épaisseur | 125 | 641 | 284 | 5,1 | 53% |
| | ½ épaisseur | 175 | > 2000 | 591 | > 11 | |
| D | Surface | 99 | 284 | 168 | 2,9 | |
| | ¼ épaisseur | 95 | 364 | 186 | 3,8 | 10% |
| | ½ épaisseur | 105 | 324 | 184 | 3,1 | |

On constate que le produit selon l'invention présente une taille de grain plus isotrope et plus homogène dans l'épaisseur que celle des autres alliages. Ces caractéristiques sont très favorables pour l'homogénéité de l'usinage et des propriétés après usinage. L'échantillon D pour lequel aucune addition de chrome n'a été effectuée présente notamment un indice d'anisotropie plus élevé que l'échantillon A.

Les contraintes résiduelles dans l'épaisseur ont été évaluées en utilisant la méthode d'usinage étape par étape de barreaux rectangulaires prélevés en pleine épaisseur dans les directions L et TL, décrite par exemple dans la publication "Development of New Alloy for Distortion Free Machined Aluminum Aircraft Components", F.Heymes, B.Commet, B.Dubost, P.Lassince, P.Lequeu, GM.Raynaud, in 1st International Non-Ferrous Processing & Technology Conference, 10-12 March 1997 - Adams's Mark Hotel, St Louis, Missouri. Cette méthode s'applique principalement aux plaques dont la longueur et la largeur sont notablement plus élevées que l'épaisseur et pour lesquelles l'état de contrainte résiduelle peut être raisonnablement considéré comme étant biaxial avec ses deux composantes principales dans les directions L et T (i.e. pas de contrainte résiduelle dans la direction S) et tel que le niveau de contraintes résiduelles varie seulement dans le sens S. Cette méthode est basée sur la mesure de la déformation de deux barres rectangulaires de pleine épaisseur qui sont découpées dans la plaque le long des directions L et TL. Ces barres sont usinées vers le bas dans la direction S étape par étape, et à chaque étape la flèche est mesurée, ainsi que l'épaisseur de la barre usinée. La largeur de la barre était de 30 mm. La barre doit être suffisamment longue pour éviter tout effet de bord sur les mesures. Une longueur de 400 mm a été utilisée.

Les mesures sont effectuées après chaque passe d'usinage.

Après chaque passe d'usinage, la barre est retirée de l'étau, et un temps de stabilisation est observé avant que la mesure de déformation soit réalisée, de manière à obtenir une température homogène dans la barre après usinage. À chaque étape i, l'épaisseur h(i) de chaque barre et la flèche f(i) de chaque barre sont collectées.

Ces données permettent de calculer le profil de contraintes résiduelles dans la barre, correspondant à la contrainte $\sigma(i)_L$ et à la contrainte $\sigma(i)_{LT}$ sous la forme d'une moyenne dans la couche enlevée lors du i étape, données par les formules suivantes, dans lesquelles $E$ est le module d'Young, $lf$ est la longueur entre les appuis utilisée pour la mesure de flèche et $v$ est le coefficient de Poisson :

de i = 1 à N-1

$$u(i)_L = -E\frac{4}{3}\frac{E}{lf^2}\left[f(i+1)_L - f(i)_L\right]\frac{h^3(i+1)}{h(i)(h(i)-(h(i+1))} - S(i)_L$$

$$S(i)_L = \frac{4E}{lf^2}\sum_{k=1}^{i-1}\left[f(k+1)_L - f(k)_L\right]\left[-(h(i)+(h(i+1)) + \frac{h(k+1)(3h(k)-h(k+1))}{3h(k)}\right]$$

$$\sigma(i)_L = \frac{u(i)_L + vu(i)_{LT}}{1-v^2}$$

$$\sigma(i)_{LT} = \frac{u(i)_{LT} + vu(i)_L}{1-v^2}$$

Enfin, la densité d'énergie élastique stockée dans la barre $W_{tot}$ peut être calculée à partir des valeurs de contraintes résiduelles à l'aide des formules suivantes:

$$W_{tot} = W_L + W_{LT}$$

avec

$$W_L(kJ/m^3) = \frac{500}{Eth}\sum_{i=1}^{N-1}\sigma_L(i)\left[\sigma_L(i) - v\sigma_{LT}(i)\right]dh(i)$$

$$W_{LT}(kJ/m^3) = \frac{500}{Eth}\sum_{i=1}^{N-1}\sigma_{LT}(i)\left[\sigma_{LT}(i) - v\sigma_L(i)\right]dh(i)$$

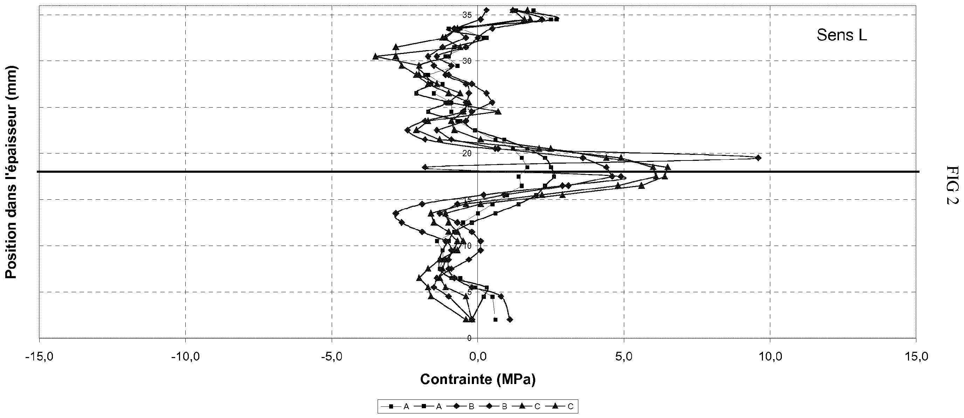

Le profil de contrainte dans l'épaisseur pour la direction L est donnée dans la figure 2. L'énergie totale mesurée $W_{tot}$ était de 0,03 kJ/m$^3$ pour l'échantillon A, 0,04 kJ/m$^3$ pour l'échantillon B et 0.05 kJ/m$^3$ pour l'échantillon C. L'échantillon A selon l'invention présente donc un plus faible niveau de contraintes internes ce qui est avantageux pour l'usinage des pièces.

Deux traitements d'anodisation ont été utilisés pour évaluer les propriétés des produits obtenus. Les produits ont été caractérisés dans le plan L - TL en surface (ou après un léger usinage) ou après usinage jusqu'à mi-épaisseur.

Dans le traitement I le produit est dégraissé, décapé à l'aide d'une solution alcaline, puis neutralisé avec une solution d'acide nitrique avant de subir une anodisation à une température comprise entre 0 et 5 °C dans un bain sulpho-oxalique (acide sulfurique 180 g/l + acide oxalique 14g/l). Après anodisation, un traitement d'hydratation de la couche anodique est réalisé en deux étapes : 20 min à 50 °C dans de l'eau déionisée puis environ 80 min dans de l'eau déionisée à ébullition en présence d'un additif antipoudrant dérivé de triazine le Anodal-SH1®. La couche anodique obtenue avait une épaisseur d'environ 40 $\mu$m.

Dans le traitement II le produit est dégraissé, décapé à l'aide d'une solution alcaline, puis neutralisé avec une solution d'acide nitrique avant de subir une anodisation à une température d'environ 20 °C dans un bain sulpho-oxalique (acide sulfurique 160 g/l + acide oxalique 20g/l + 15 g/l de glycérol). Après anodisation, un traitement d'hydratation de la couche anodique est réalisé en deux étapes : 20 min à 50 °C dans de l'eau déionisée puis environ 80 min dans de l'eau déionisée à ébullition en présence d'un additif antipoudrant dérivé de triazine le Anodal-SH1®. La couche anodique obtenue avait une épaisseur d'environ 35 ou 50 $\mu$m.

Les couches anodiques ont été caractérisées par les tests suivants.

La tension de claquage caractérise la tension à laquelle un premier courant électrique traverse la couche anodique. La méthode de mesure est décrite dans la norme EN ISO 2376:2010. Les valeurs sont indiquées en valeur absolue après mesure en courant continu (DC).

Le « test de bulles » est un test de corrosion qui permet de caractériser la qualité de la couche anodique en mesurant la durée d'apparition des premières bulles dans une solution d'acide chlorhydrique. Une surface plane de 20 mm de diamètre de l'échantillon est mise en contact à température ambiante, avec une solution à 5% en masse d'HCl. La durée caractéristique est la durée à partir de laquelle un flux continu de bulles de gaz provenant d'au moins un point discret de la surface de l'aluminium anodisé est visible.

Les résultats mesurés en surface et à mi-épaisseur sont présentés dans le tableau 4.

Tableau 4 - caractérisation des produits après anodisation

| Position | Anodisation | Alliage | Epaisseur de couche visée ($\mu$m) | Test de bulles (min) | Tension de claquage (KV) |
|---|---|---|---|---|---|
| Surface | Type I | A | 40 | 50 | 1,5 |
| | | B | 40 | 25 | 2,2 |
| | | C | 40 | 180 | 2,6 |
| | Type II | A | 35 | 2400 | 2,0 |
| | | A | 50 | 3000 | 2,3 |
| | | B | 35 | 1980 | 3,0 |
| | | C | 35 | 2700 | 2,8 |
| | | D | 30 | >1440 | 2.4 |
| Mi-épaisseur | Type I | A | 40 | 50 | 1,8 |
| | | B | 40 | 135 | 2,0 |
| | | C | 40 | 75 | 2,3 |
| | Type II | A | 35 | 2900 | 2,1 |
| | | A | 50 | 3000 | 2,2 |
| | | B | 35 | 720 | 2,8 |
| | | C | 35 | 1700 | 2,8 |

Le produit selon l'invention présente quelle que soit le traitement de surface une grande homogénéité de propriétés entre surface et mi-épaisseur. Les durées au test de bulles sont particulièrement élevées avec l'anodisation selon l'invention.

Exemple 2

Dans cet exemple, on a étudié l'effet de la présence de glycérol dans la solution d'anodisation. Ainsi dans le traitement type I décrit ci-dessus on a ajouté pour certains essais 15 g/l de glycérol et dans le traitement type II on n'a pas ajouté pour certains essais le glycérol.

Les résultats sont présentés dans le Tableau 5.

Tableau 5 - Effet de la présence de glycérol dans la solution d'anodisation

| Anodisation | | Alliage. | Position | Epaisseur de couche ($\mu$m) | Test de bulles (min) | Tension de claquage (KV) |
|---|---|---|---|---|---|---|
| Type I | sans glycérol | A | Surface | 35-40 | 50 | 1,5 |
| | | A | Surface | 64 | 94 | 2,6 |
| | Glycerol 15 g/l | A | Surface | 52 | 270 | 1,7 |
| Type II | sans glycérol | A | Surface | 35 | 1380 | 1,3 |
| | | A | Surface | 58 | 865 | 2,2 |
| | Glycerol 15 g/l | A | Surface | 35 | 2400 | 2,0 |
| | | A | Surface | 48 | 3000 | 2,2 |

La présence de glycérol lors de l'anodisation permet d'améliorer de façon très significative la durée obtenue lors du test de bulles, en particulier pour l'anodisation de type II.

Exemple 3

Dans cet exemple, on a évalué la résistance à la corrosion de tôles épaisses en alliage selon l'invention, en comparaison avec une tôle en alliage 6061 de référence.

Une tôle en alliage A d'épaisseur 102 mm a été préparée selon le procédé décrit dans l'exemple 1. Une tôle en alliage 6061 de référence a également était préparée jusqu'à une épaisseur de 100 mm. Les tôles obtenues ont ensuite été traitées par le traitement de surface de type II décrit dans l'exemple 1. Les produits ainsi obtenus ont été caractérisés par le test de bulles décrit dans l'exemple 1. La durée d'apparition de bulles d'hydrogène était de 60 mn pour les tôles en alliage 6061 alors qu'elle était de 320 mn pour les tôles en alliage A.

## Revendications

1. Elément de chambre à vide obtenu par usinage et traitement de surface d'une tôle d'épaisseur au moins égale à 10 mm en alliage d'aluminium de composition, en % en poids, Si : 0,4 - 0,7 ; Mg : 0,4 - 0,7 ; Ti : 0,01 - < 0,15, Fe 0,05 à 0,2 ; Cu < 0,04 ; Mn < 0,4 ; Cr : 0,01 - < 0,1 ; Zn < 0,04 ; autres éléments < 0,05 chacun et < 0,15 au total, reste aluminium.

2. Elément selon la revendication 1 dans lequel la teneur en manganèse est inférieure à 0,04 % en poids et de préférence inférieure à 0,02 % en poids.

3. Elément selon une quelconque des revendications 1 à 2 dans lequel la teneur en chrome est de 0,01 à 0,04 % en poids et de préférence de 0,01 à 0,03 % en poids.

4. Elément selon une quelconque des revendications 1 à 3 dans lequel la teneur en fer est de 0,1 à 0,2 % en poids.

5. Elément selon une quelconque des revendications 1 à 4 dans lequel la teneur en silicium est de 0,5 à 0,6 % en poids.

6. Elément selon une quelconque des revendications 1 à 5 dans lequel la teneur en magnésium est de 0,5 à 0,6 % en poids.

7. Elément selon une quelconque des revendications 1 à 6 dans lequel la teneur en cuivre est inférieure à 0,02 % en poids et de préférence inférieure à 0,01 % en poids.

8. Elément selon une quelconque des revendications 1 à 7 dans lequel la teneur en zinc est inférieure à 0,02 % en poids et de préférence inférieure à 0,001 % en poids.

9. Elément selon une quelconque des revendications 1 à 8 dans lequel la teneur en titane est de 0,01 à 0,1 % en poids et de préférence de 0,01 à 0,05 % en poids.

10. Elément selon une quelconque des revendications 1 à 9 dans lequel ladite tôle est telle que la variation dans l'épaisseur de la longueur moyenne d'interception linéaire dans le plan L/TC, nommée $\bar{\ell}_{\ell(90°)}$ selon la norme ASTM E112, est inférieure à 30 % et de préférence inférieure à 20% et/ou , à mi-épaisseur l'indice d'anisotropie $AI_\ell = \bar{\ell}_{\ell(0°)}$ / $\bar{\ell}_{\ell(90°)}$ mesuré selon la norme ASTM E112 est inférieur à 3.

11. Elément selon une quelconque des revendications 1 à 10 dans lequel ladite tôle est telle que son épaisseur est comprise entre 10 et 60 mm et sa densité d'énergie élastique stockée $W_{tot}$ est inférieure à 0,04 kJ/m$^3$.

12. Elément selon une quelconque des revendications 1 à 11 dans lequel ledit traitement de surface comprend une anodisation réalisée à une température comprise entre 10 et 30 °C avec une solution comprenant 100 à 300 g/l d'acide sulfurique et 10 à 30 g/l d'acide oxalique et 5 à 30 g/l d'au moins un polyol.

13. Elément selon la revendication 12 dans lequel ladite tôle est telle que son épaisseur est comprise entre 10 et 60 mm qu'elle présente à mi-épaisseur une durée d'apparition de bulles d'hydrogène dans une solution d'acide chlorhydrique 5% supérieure à 1800 min ou dans lequel ladite tôle est telle que son épaisseur est supérieure à 60 mm et présente en surface une durée d'apparition de bulles d'hydrogène dans une solution d'acide chlorhydrique 5% d'au moins 180 min.

**Patentansprüche**

1. Vakuumkammerelement, welches erhalten wird durch Bearbeitung und Oberflächenbehandlung eines mindestens 10 mm dicken Blechs aus einer Aluminiumlegierung folgender Zusammensetzung (in Gew.-%): Si: 0,4 - 0,7 ; Mg: 0,4 - 0,7 ; Ti: 0,01 - <0,15 ; Fe 0,05 - 0,2 ; Cu < 0,04 ; Mn < 0,4 ; Cr: 0,01 - < 0,1 ; Zn < 0,04 ; weitere Elemente jeweils < 0,05 und insgesamt < 0,15, Rest Aluminium.

2. Element nach Anspruch 1, wobei der Mangangehalt weniger als 0,04 Gew.-% und vorzugsweise weniger als 0,02 Gew.-% beträgt.

3. Element nach irgendeinem der Ansprüche 1 bis 2, wobei der Chromgehalt 0,01 bis 0,04 Gew.-% und vorzugsweise 0,01 bis 0,03 Gew.-% beträgt.

4. Element nach irgendeinem der Ansprüche 1 bis 3, wobei der Eisengehalt 0,1 bis 0,2 Gew.-% beträgt.

5. Element nach irgendeinem der Ansprüche 1 bis 4, wobei der Siliziumgehalt 0,5 bis 0,6 Gew.-% beträgt.

6. Element nach irgendeinem der Ansprüche 1 bis 5, wobei der Magnesiumgehalt 0,5 bis 0,6 Gew.-% beträgt.

7. Element nach irgendeinem der Ansprüche 1 bis 6, wobei der Kupfergehalt weniger als 0,02 Gew.-% und vorzugsweise weniger als 0,01 Gew.-% beträgt.

8. Element nach irgendeinem der Ansprüche 1 bis 7, wobei der Zinkgehalt weniger als 0,02 Gew.-% und vorzugsweise weniger als 0,001 Gew.-% beträgt.

9. Element nach irgendeinem der Ansprüche 1 bis 8, wobei der Titangehalt 0,01 bis 0,1 Gew.-% und vorzugsweise 0,01 bis 0,05 Gew.-% beträgt.

10. Element nach irgendeinem der Ansprüche 1 bis 9, wobei das Blech so beschaffen ist, dass die Dickenvariation der mittleren Linienschnittlänge in der Ebene L/TC, genannt $\bar{\ell}_{\ell(90°)}$ nach der Norm ASTM E112, weniger als 30 % und vorzugsweise weniger als 20 % beträgt und/oder auf halber Dicke die Anisotropiezahl $AI_\ell = \bar{\ell}_{\ell(0°)} / \bar{\ell}_{\ell(90°)}$, gemessen nach der Norm ASTM E112, kleiner als 3 ist.

**EP 3 168 316 B1**

**11.** Element nach irgendeinem der Ansprüche 1 bis 10, wobei das Blech so beschaffen ist, dass seine Dicke zwischen 10 und 60 mm liegt und seine gespeicherte Federenergiedichte $W_{tot}$ weniger als 0,04 kJ/m$^3$ beträgt.

**12.** Element nach irgendeinem der Ansprüche 1 bis 11, wobei die Oberflächenbehandlung ein Anodisieren umfasst, welches bei einer Temperatur zwischen 10 und 30 °C mit einer Lösung durchgeführt wird, die 100 bis 300 g/l Schwefelsäure und 10 bis 30 g/l Oxalsäure und 5 bis 30 g/l wenigstens eines Polyols enthält.

**13.** Element nach Anspruch 12, wobei das Blech so beschaffen ist, dass seine Dicke zwischen 10 und 60 mm liegt und auf halber Dicke die Dauer des Auftretens von Wasserstoffbläschen in einer fünfprozentigen Salzsäurelösung mehr als 1800 Minuten beträgt, oder wobei das Blech so beschaffen ist, dass seine Dicke über 60 mm liegt und oberflächenseitig die Dauer des Auftretens von Wasserstoffbläschen in einer fünfprozentigen Salzsäurelösung wenigstens 180 Minuten beträgt.

**Claims**

**1.** Element of a vacuum chamber obtained by machining and surface treatment of a sheet at least 10 mm thick made of aluminium alloy with the following composition, in % by weight, Si: 0.4 - 0.7; Mg: 0.4 - 0.7; Ti: 0.01 - < 0.15; Fe: 0.05 to 0.2; Cu < 0.04; Mn < 0.4; Cr: 0.01 - < 0.1; Zn < 0.04; other elements < 0.05 each and < 0.15 in total, the remainder being aluminium.

**2.** Element according to claim 1, wherein the manganese content is less than 0.04% by weight and preferably less than 0.02% by weight.

**3.** Element according to any one of claims 1 or 2, wherein the chromium content ranges from 0.01 to 0.04% by weight and preferably from 0.01 to 0.03% by weight.

**4.** Element according to any one of claims 1 to 3, wherein the iron content ranges from 0.1 to 0.2% by weight.

**5.** Element according to any one of claims 1 to 4, wherein the silicon content ranges from 0.5 to 0.6% by weight.

**6.** Element according to any one of claims 1 to 5, wherein the magnesium content ranges from 0.5 to 0.6% by weight.

**7.** Element according to any one of claims 1 to 6, wherein the copper content is less than 0.02% by weight and preferably less than 0.01% by weight.

**8.** Element according to any one of claims 1 to 7, wherein the zinc content is less than 0.02% by weight and preferably less than 0.001% by weight.

**9.** Element according to any one of claims 1 to 8, wherein the titanium content ranges from 0.01% to 0.1% by weight and preferably from 0.01 to 0.05% by weight.

**10.** Element according to any one of claims 1 to 9, wherein said sheet is such that the variation in the thickness of the average linear interception length in the L/TC plane, called $\overline{\ell}_{\ell(90°)}$ according to standard ASTM E112, is less then 30% and preferably less than 20%, and/or at mid-thickness the anisotropy index $AI_\ell = \overline{\ell}_{\ell(0°)}/\overline{\ell}_{\ell(90°)}$ measured according to ASTM standard E112 is less than 3.

**11.** Element according to any one of claims 1 to 10, wherein said sheet is such that its thickness is between 10 and 60 mm and its stored elastic energy density $W_{tot}$ is less than 0.04 kJ/m$^3$.

**12.** Element according to any one of claims 1 to 11, wherein said surface treatment comprises an anodization made at a temperature of between 10 and 30°C with a solution comprising 100 to 300 g/l of sulphuric acid and 10 to 30 g/l of oxalic acid and 5 to 30 g/l of at least one polyol.

**13.** Element according to claim 12, wherein said sheet is such that its thickness is between 10 and 60 mm, it features at mid-thickness a duration of appearance of hydrogen bubbles in a 5% hydrochloric acid solution longer than 1800 minutes, or wherein said sheet is such that its thickness is more than 60 mm and it features on the surface a duration of appearance of hydrogen bubbles in a 5% hydrochloric acid solution of at least 180 minutes.

FIG 1

FIG 2

FIG 3

## RÉFÉRENCES CITÉES DANS LA DESCRIPTION

**Documents brevets cités dans la description**

- US 6713188 B
- US 7033447 B
- US 6686053 B
- US 20090050485 A
- US 20100018617 A
- US 2001019777 A
- JP 2001220637 A
- WO 201189337 A
- US 6066392 A
- US 6027629 A
- US 7005194 B
- US 3524799 A

**Littérature non-brevet citée dans la description**

- Development of New Alloy for Distortion Free Machined Aluminum Aircraft Components. **F.HEYMES ; B.COMMET ; B.DUBOST ; P.LASSINCE ; P.LEQUEU ; GM.RAYNAUD.** 1st International Non-Ferrous Processing & Technology Conference. Adams's Mark Hotel